# EUROPEAN PATENT APPLICATION

(11) **EP 0 546 435 A2**
(43) Date of publication of application: **16.06.1993**
(21) Application number: 92120546.4
(22) Date of filing: 02.12.1992
(51) Int. Cl.: H01L 23/495

(54) **Protection device for integrated circuit associated with relative supports**

(30) Priority: 12.12.1991 IT MI913334
(71) Applicant: SGS-THOMSON MICROELECTRONICS S.r.l., I-20041 Agrate Brianza (Milano) (IT)
(72) Inventor: Cazzaniga, Claudio, I-20041 Agrate Brianza (Milano) (IT); Massironi, Angelo, I-20049 Concorezzo (Milano) (IT)
(74) Representative: Giambrocono, Alfonso, Dr. Ing.

(57) **Abstract**

A protection device for an integrated circuit (2) associated with a corresponding support (1), said circuit (2) and that part (3) of the support (1) to which it is connected being surrounded by a usual insulating resin (10), the circuit (2) comprising a plurality of lugs (4), electrical connections (7) being provided connecting said circuit (2) to the support (1). On this latter, delimiting means (13, 14) are provided laterally to the integrated circuit (2) to protect its sides (16, 17) at least from moisture, said delimiting means (13, 14) at least partly defining in the support (1) a seat (15) in which the integrated circuit (2) is inserted.

## Description

This invention relates to a protection device for an integrated circuit associated with a corresponding support, said circuit and that part of the support to which it is connected being surrounded by a usual insulating resin, the circuit comprising a plurality of lugs, electrical connections being provided connecting said circuit to the support.

As is well known, a product comprising an integrated circuit arranged on a respective support is sometimes subject to electrical damage (which can also result in its non-operation or incorrect operation) due to poor sealing of the resin surrounding the circuit. In particular, moisture can seep into the circuit via the members forming the electrical connection between the circuit and its support.

In addition, in a product of the aforesaid type it is known to use a suitable generally lead-tin bonding alloy for fixing the circuit to the support. This bonding is achieved by depositing the alloy in its molten state on the support and then placing the circuit on it. As the alloy is in a liquid state it flows over the support and on placing the circuit on it can deposit itself on the usual regions or pads present on this latter, and at which the electrical connections to the support are to be made. When the alloy cools and solidifies, insulating layers are created at these pads, with the result that correct connection cannot be achieved between said electrical connections and the circuit. This results in obvious electrical problems.

An object of the present invention is to provide a protection device for an integrated circuit associated with a corresponding support which protects this circuit from moisture.

A further object is to provide a device of the stated type which enables a very reliable bond to be obtained between the circuit and the relative support.

A further object is to provide a device of the stated type which limits the movement of the bonding alloy during its use for fixing the integrated circuit to the support, so preventing this alloy from reaching circuit regions which are to cooperate with electrical connections, and hence allowing improved electrical connection between the circuit and the support.

A further object is to provide a reliable device of simple, low-cost construction.

These an further objects which will be apparent to the expert of the art are attained by a device of the stated type, characterised by comprising delimiting and protection means rising from that surface or face of the support with which the circuit is associated, said protection means being positioned in correspondence with at least one side of said circuit and spaced from this latter, said delimiting and protection means at least partly defining on said support face a seat in which the integrated circuit is inserted.

The present invention will be more apparent from the accompanying drawing, which is provided by way of non-limiting example and in which:

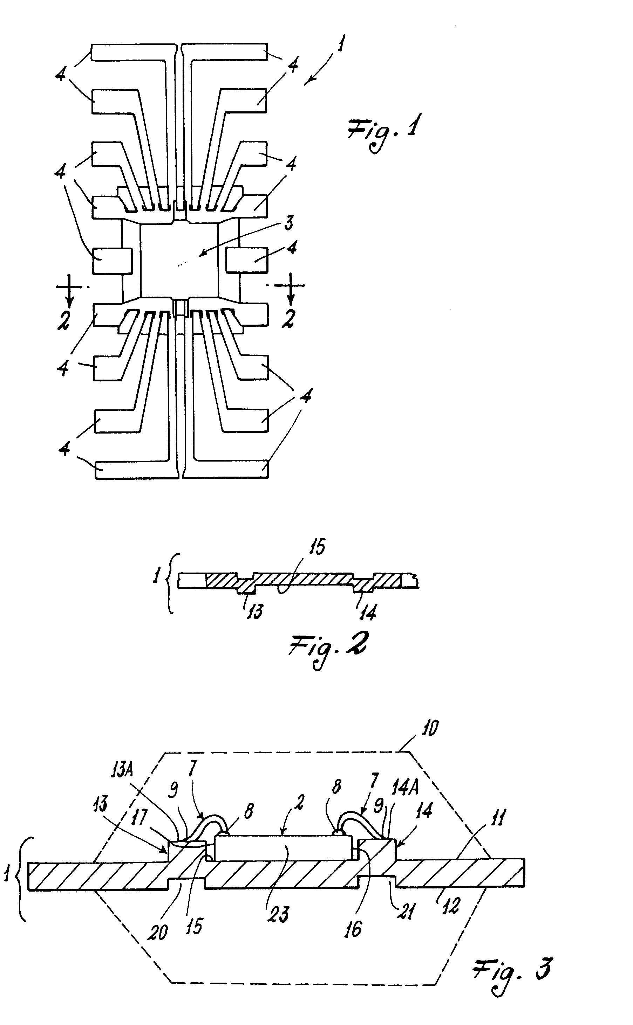

Figure 1 is a plan view of an integrated support comprising the device according to the invention;
Figure 2 is a section on the line 2-2 of Figure 1; and
Figure 3 is a cross-section through a support as shown in Figure 1, with which an integrated circuit is associated.

With reference to said figures, a support 1 is arranged to cooperate with a usual integrated circuit 2. The support is a usual power support having a central region 3 from which there extend a plurality of arms or lugs 4 acting as heat dissipators for the support 1 (in particular for the region 3) and as elements for connection to other usual or corresponding supports.

The region 3 is arranged to directly support the circuit 2. This latter is fixed to said region by a usual bonding alloy, for example of the lead-tin covering type.

The circuit 2 is connected to the support 1 via usual filiform connection elements 7 having one end 8 fixed in known manner to the circuit and the other end 9 to the support.

Finally, the circuit and the support are covered with a usual resin 10, which surrounds both of them and is applied to both faces.

According to the invention, on the face 11 of the support 1 there are provided, at least in correspondence with the region 3, two opposing parallel shoulders 13 and 14 delimiting a portion 15 of the region 3 for receiving the circuit 2 and having dimensions at least slightly greater than those of the circuit.

In particular, these shoulders are positioned in correspondence with the larger-dimension sides 16, 17 of the circuit 2, to provide greater protection to said circuit against any moisture which can reach it in significant amount (and create obvious problems), particularly at these sides.

The shoulders 13 and 14 have a height from that face 11 of the support 1 from which they rise which is substantially equal to that of the circuit 2 on said face. This allows the circuit to be protected against accidental impact which it may receive either laterally or perpendicularly to it. In addition the portion 15 (which is depressed below the tops 13A and 14A of the shoulders 13 and 14) defines a "containing basin" for the bonding alloy used for fixing the circuit 2 to the support 1. When this alloy has been deposited on the face 11 of the support in its region 3, or rather on the portion 15 of this latter region, it is not able to move and remains substantially within this portion. This prevents the alloy from depositing on the circuit 2 and preventing optimum connection between the filiform elements 7 and said circuit 2.

In this respect, the ends 9 of these elements are joined to the tops 13A and 14A of the shoulders. This also facilitates the formation of the connection between the parts (elements 7, circuit 2 and support 1).

Finally recesses 20 and 21 are provided in the face 12 of the support 1 in positions corresponding with the shoulders 13 and 14. This enables the position of the portion 15 (and hence the part where the circuit 2 is to be positioned) to be determined by viewing the face 12 of said support, hence facilitating the placing of the circuit 2 on the face 11 thereof.

One embodiment of the invention has been described. However other embodiments are possible, such as an embodiment in which shoulders analogous to the described shoulders 13 and 14 are positioned in correspondence with the minor sides of the circuit 2 (of which only one 23 is shown in Figure 3).

Such embodiments are to be considered as falling within the scope of the present document.

## Claims

1. A protection device for an integrated circuit (2) associated with a corresponding support (1), said circuit (2) and that part (3) of the support (1) to which it is connected being surrounded by a usual insulating resin (10), the circuit (2) comprising a plurality of lugs (4), electrical connections (7) being provided connecting said circuit (2) to the support (1), characterised by comprising delimiting and protection means (13, 14) rising from that surface or face (11) of the support (1) with which the circuit (2) is associated, said protection means (13, 14) being positioned in correspondence with at least one side (16, 17) of said circuit (2) and spaced from this latter, said delimiting and protection means (13, 14) at least partly defining on said face (11) of the support (1) a seat (15) in which the integrated circuit (2) is inserted.

2. A device as claimed in claim 1, characterised in that the delimiting and protection means are at least one shoulder (13) rising from that face (11) of the support (1) on which the integrated circuit (2) is positioned.

3. A device as claimed in claim 1, characterised in that the delimiting and protection means are shoulders (13, 14) rising from that face (11) of the support (1) on which the integrated circuit (2) is positioned, these shoulders being mutually parallel and spaced apart.

4. A device as claimed in claim 2 or 3, characterised in that each shoulder (13, 14) rises from the corresponding face (11) of the support (1) to a height substantially corresponding to that of the circuit (2) on said support.

5. A device as claimed in claim 1, characterised in that the seat (15) defined by the delimiting and protection means has at least slightly larger dimensions than the integrated circuit (2).

6. A device as claimed in the preceding claims, characterised in that the electrical connections (7) have a first end (9) connected to the integrated circuit (2) and their second end (9) associated with a corresponding shoulder (13, 14).

7. A device as claimed in claim 1, characterised in that in the opposite face (12) to the face (11) to which the circuit (2) is fixed, the support (1) comprises recesses (20, 21) in positions corresponding to those of the delimiting and protection means (13, 14) present on the other face (11).

8. A device as claimed in claim 1, characterised in that the delimiting and protection means are provided along each side of the integrated circuit (2).
